# EUROPÄISCHE PATENTSCHRIFT

(11) **EP 4 214 055 B1**
(45) Veröffentlichungstag und Bekanntmachung des Hinweises auf die Patenterteilung: **18.06.2025**
(21) Anmeldenummer: 22789847.5
(22) Anmeldetag: 12.09.2022
(51) Int. Cl.: B32B 41/00, B32B 37/00, B32B 37/06, B32B 37/18, B32B 38/00, B32B 39/00, H05K 3/46, H05K 13/08, B32B 15/20, B32B 27/06, B32B 27/14

(54) **VERFAHREN ZUR HERSTELLUNG VON MEHRSCHICHTIGEN LEITERPLATTEN**
METHOD FOR THE PRODUCTION OF MULTILAYER CIRCUIT BOARDS
PROCÉDÉ DE FABRICATION DE CARTES DE CIRCUITS MULTICOUCHES

(30) Priorität: 14.09.2021 DE 102021123685
(43) Veröffentlichungstag der Anmeldung: 26.07.2023
(73) Patentinhaber: Ulrich Rotte Anlagenbau und Fördertechnik GmbH, 33154 Salzkotten (DE)
(72) Erfinder: ROTTE, Ulrich, 33154 Salzkotten (DE)
(74) Vertreter: Wickord, Wiro
(86) Internationale Anmeldenummer: PCT/DE2022/100670
(87) Internationale Veröffentlichungsnummer: WO 2023/041112

(56) Entgegenhaltungen:
- DE-A1- 102016 113 985
- IT-A1- 201900 001 739
- US-A1- 2014 020 245

## Beschreibung

Die Erfindung betrifft ein Verfahren zur Herstellung von mehrschichtigen Leiterplatten nach dem Oberbegriff des Patentanspruchs 1.

Mehrschichtige Leiterplatten werden heute üblicherweise in einer Etagen-Heizpresse hergestellt, wobei im Rahmen einer experimentellen Erprobung des Fertigungsverfahrens geeignete Prozessparameter für den Betrieb der Etagen-Pressheizung bestimmt werden und die sich anschließende Serienfertigung unter Verwendung der so experimentell bestimmten Prozessparameter durchgeführt wird. Um die notwendigen Parameter bei der experimentellen Erprobung zu ermitteln, werden vorbereitend in dem Konfektionsverfahrensschritt in dem Werkzeug insbesondere kupferbasierte Funktionsschichten und Isolationsschichten abwechselnd übereinandergelegt. Zwischen zwei dieser Schichten wird ein Temperatursensor als Messwertgeber positioniert und es wird eine Signalleitung aus dem Werkzeug hinausgeführt. Der Temperatursensor bildet dabei einen verlorenen Sensor, der nicht wiederverwendet werden kann.

Ein freies Ende der Signalleitung wird typischerweise temporär an einer Außenseite des Werkzeugs festgelegt, beispielsweise mittels eines Klebestreifens. Das bestückte Werkzeug wird dann in dem Bestückungsverfahrensschritt mit einer Vielzahl weiterer Werkzeuge in eine Etagen-Heizpresse eingesetzt. Das Werkzeugunterteil liegt dabei auf einer Heizplatte der Etagen-Heizpresse auf und ist relativ zu demselben ausgerichtet beziehungsweise positioniert. Die Heizplatte dient als Träger für das Werkzeug. Das Werkzeugoberteil ist beabstandet zu einer oberhalb desselben angeordneten weiteren Heizplatte vorgesehen, die - mit Ausnahme der obersten Heizplatte - ein weiteres bestücktes Werkzeug trägt.

Um nun in der experimentellen Erprobung Messwerte zu ermitteln und Verfahrensparameter bestimmen zu können, werden die freien Enden der Signalleitung vom jeweiligen Werkzeug abgelöst und mit einer Datenspeicherbox verbunden, die mit den Heizplatten und den Werkzeugen in einer Thermokompressionskammer der Etagen-Heizpresse angeordnet ist. Anschließend wird die Thermokompressionskammer geschlossen und die Heizplatten in einem sich anschließenden Fertigungsverfahrensschritt so gegeneinander verfahren, dass sich die Werkzeuge sandwichartig zwischen zwei Heizplatten befinden und die bestückten Werkzeuge erwärmen, wobei die Funktions- und Isolationsschichten im Werkzeug unter Druck verbunden werden. Während dieses Vorgangs wird insbesondere die Temperatur im Inneren des Werkzeugs mittels des Temperatursensors gemessen.

Die Bestimmung der Prozessparameter erfolgt im Rahmen der experimentellen Erprobung offline. Während der experimentellen Erprobung werden die Daten lediglich erfasst und in der Datenspeicherbox gesammelt. Die Aufbereitung und Auswertung der Daten erfolgt nachgelagert. Die während der experimentellen Erprobung ermittelten Messwerte dienen daher gerade nicht dazu, um steuernd oder regelnd in den laufenden Fertigungsverfahrensschritt einzugreifen. Darüber hinaus ist der Aufwand der manuellen Verkabelung der einzelnen Temperatursensoren in der warmen Etagen-Heizpresse aufgrund des beengten Raumangebots und der dort vorherrschenden Temperaturen von typischerweise 100 °C oder mehr aufwendig, zeitintensiv und für den Maschinenführer mit dem Risiko behaftet, sich zu verbrennen.

In Ausnahmefällen wird das vorstehend für den Fall der experimentellen Erprobung beschriebene Vorgehen auch im Rahmen der Serienfertigung der Leiterplatten angewandt. Aufgrund des hohen Zeitaufwands und der damit einhergehenden hohen Kosten wird dieser Aufwand jedoch nur in Ausnahmefällen getrieben, beispielsweise wenn die herzustellenden Leiterplatten in sicherheitskritischen Anwendungen eingesetzt werden und der Anwender daher besondere Anforderungen an die Überwachung und Dokumentation der Fertigung stellt. Eine Verwendung der Messwerte zum online-Eingriff in den laufenden Fertigungsverfahrensschritt ist aber auch in diesem Fall nicht realisiert.

Die IT 2019 0000 1739 A1 offenbart ein Herstellverfahren für mehrschichtige Leiterplatten.

Aus der DE 10 2016 113 985 A1 ist eine Etagen-Heizpresse bekannt, die geeignet ist, für die Herstellung mehrschichtiger Leiterplatten verwendet zu werden.

Aufgabe der vorliegenden Erfindung ist es, ein verbessertes Verfahren zur Herstellung von mehrschichtigen Leiterplatten anzugeben.

Zur Lösung der Aufgabe weist die Erfindung die Merkmale des Patentanspruchs 1 auf.

Der besondere Vorteil der Erfindung besteht darin, dass durch die online-Erfassung und Verarbeitung der Messwerte ein Eingriff in den laufenden

Fertigungsverfahrensschritt möglich wird. Der Fertigungsverfahrensschritt kann in Bezug auf relevante Prozessparameter, beispielsweise die Temperatur in der Thermokompressionskammer oder in dem Werkzeug und/oder dem Druck, mit dem das Werkzeug beaufschlagt wird, überwacht und nachjustiert werden. Hierdurch kann es gelingen, den Prozessverlauf zu optimieren und gegebenenfalls früher zu beenden als vorgesehen. In der Folge reduziert sich die Prozesszeit beziehungsweise die Zyklusdauer und der Durchsatz kann erhöht werden. Der höhere Durchsatz führt dann unmittelbar zu einer Kostenreduzierung beziehungsweise zu einer Steigerung der Fertigungsstückzahlen.

Zudem kann durch die verbesserte Überwachung des laufenden Fertigungsverfahrensschritts ein Qualitätsmonitoring installiert werden, welches es erlaubt, Fehler im Fertigungsverfahren zu identifizieren, bevor die hergestellten Leiterplatten ausgeliefert werden und in den Markt gelangen. Die Produktqualität kann hierdurch erhöht werden. Darüber hinaus reduzieren sich die Kosten für die Fehlerbehebung beziehungsweise Rücknahme defekter Geräte. Insbesondere bei sicherheitskritischen Anwendungen kann des Weiteren einer erhöhten Anforderung an die Dokumentation der Fertigung Genüge getan und das Ausfallrisiko gesenkt werden.

Soweit im Rahmen der vorliegenden Erfindung von einer Fertigungssteuereinrichtung und/oder der Steuerung des laufenden Fertigungsverfahrensschritts gesprochen wird, fallen hierunter Steuerungs- und Regelungseinrichtungen beziehungsweise Steuerungs- und Regelungseingriffe gleichermaßen.

Nach der Erfindung können die mithilfe des Messwertgebers gewonnenen Messwerte selbst und/oder die daraus gewonnenen Daten übertragen und zur Überwachung beziehungsweise Steuerung des laufenden Fertigungsverfahrensschritts benutzt werden. Der Begriff der aus den Messwerten gewonnenen Daten umfasst insbesondere, aber nicht ausschließlich solche Daten, die durch Glättung, Komprimierung, Aggregation und/oder mathematische Verarbeitung der Messwerte des Messwertgebers gewonnen werden.

Nach einer bevorzugten Ausführungsform der Erfindung werden die mithilfe des Messwertgebers bestimmten Messwerte und/oder die daraus gewonnenen Daten hybrid, das heißt jedenfalls abschnittsweise kabellos und abschnittsweise kabelbeziehungsweise leitungsgebunden übertragen. Vorteilhaft gelingt es durch die hybride Übertragung der Messwerte und/oder der daraus gewonnenen Daten, den rauen Randbedingungen der Fertigung sowie den logistischen Herausforderungen im Fertigungsprozess gleichermaßen Genüge zu tun. Beispielsweise können die Messwerte und/oder die daraus gewonnenen Daten kabellos von einem dem Werkzeug zugeordneten Sender an eine mit dem Sender zusammenwirkende Empfangseinheit übertragen werden, die ortsfest in der Thermokompressionskammer oder außerhalb derselben als Teil einer Etagen-Heizpresse oder einer anderen geeigneten Fertigungsanlage installiert ist. Mit dem Einsetzen des Werkzeugs in die Thermokompressionskammer entfällt insofern die heute übliche Verkabelung in Bezug auf den Messwertgeber. Hierdurch sinkt die Bestückungszeit und das Risiko, dass sich der Maschinenführer beim Verkabeln der Messwertgeber verbrennt, wird reduziert. Zugleich können die im Inneren des Werkzeugs gewonnenen Messwerte kabelbeziehungsweise leitungsgebunden zu dem Sender gelangen. Dies ist angesichts der Temperatur in der Thermokompressionskammer und dem auf das Werkzeug wirkenden Druck gleichermaßen robust und fehlerunanfällig. Zudem wäre die Verwendung von Funkmesswertgebern und die kabellose Datenübertragung der Messwerte aus dem Werkzeug hinaus aufgrund dessen, dass die Messwertgeber als verlorene Sensoren nicht wiederverwendet werden können, sehr teuer. Bildet demgegenüber beispielsweise ein Thermodraht zugleich den Messwertgeber und eine von dem Messwertgeber zu dem Sender geführte Signalleitung, ist die Realisierung äußerst kostengünstig.

Nach einer Weiterbildung der Erfindung ist die mit dem Sender zusammenwirkende Empfangseinheit in der Thermokompressionskammer selbst angeordnet und die Messwerte beziehungsweise die daraus gewonnenen Daten werden kabelbeziehungsweise leitungsgebunden aus der Thermokompressionskammer hinaus zu der außerhalb der Thermokompressionskammer vorgesehenen Fertigungssteuereinrichtung geführt. Vorteilhaft kann hierdurch gewährleistet werden, dass der Sender und die Empfangseinheit in einer unmittelbaren räumlichen Nähe zueinander angeordnet sind. Die kabellose Datenübertragung kann hierdurch äußerst störungs- und energiearm erfolgen. Beispielsweise kann der Sender selbst kabellos mit Energie versorgt werden. Die weitere Datenübertragung von der Empfangseinheit zur Fertigungssteuereinrichtung wiederum ist kabel- beziehungsweise leitungsgebunden und den Fertigungsrandbedingungen entsprechend robust gestaltet.

Nach einer alternativen Ausführungsform der Erfindung kann die Empfangseinheit außerhalb der Thermokompressionskammer vorgesehen sein. Vorteilhaft ist die Empfangseinheit außerhalb der Thermokompressionskammer thermisch weniger stark belastet mit der Folge, dass insbesondere kostengünstige Empfangseinheiten verwendet werden können.

Nach einer Weiterbildung der Erfindung wird der Sender in der Thermokompressionskammer fluidisch gekühlt. Ein Kühlfluid wird hierbei über wenigstens eine Fluidleitung zu- beziehungsweise abgeführt. Als Kühlfluid kann beispielsweise Luft und bevorzugt Umgebungsluft verwendet werden. Vorteilhaft reduziert sich die thermische Belastung des Senders durch die fluidische Kühlung. Einer Beschädigung des Senders ist so entgegengewirkt.

Nach einer Weiterbildung der Erfindung werden eine Temperatur, ein Druck oder ein Feuchtewert als Messwerte bestimmt. Vorteilhaft liefern diese Messwerte die Basis, um Aussagen über die Qualität beziehungsweise Funktionsfähigkeit der Leiterplatte zu machen. Zugleich können diese Messwerte benutzt werden, um online in den laufenden Fertigungsverfahrensschritt einzugreifen. Insbesondere durch die Möglichkeit der online-Beeinflussung des laufenden Fertigungsverfahrensschritts kann es hierbei gelingen, die Prozess- beziehungsweise Zykluszeiten ohne nachteilige Beeinflussung der Qualität beziehungsweise Funktionsfähigkeit der Leiterplatten auf ein Minimum zu reduzieren. Druck und/oder Temperatur in der Thermokompressionskammer werden dabei solange aufrechterhalten und so eingestellt, dass die Funktions- und Isolationsschichten sich zuverlässig in der gewünschten Weise miteinander verbinden.

Nach einer Weiterbildung der Erfindung können eine Zieltemperatur, auf die die Thermokompressionskammer im laufenden Fertigungsverfahrensschritt aufgeheizt werden soll, und/oder ein Zieldruck, mit dem das Werkzeug im laufenden Fertigungsverfahrensschritt in der Thermokompressionskammer beaufschlagt wird, im laufenden Fertigungsverfahrensschritt abhängig von den Messwerten und/oder den daraus gewonnenen Daten über einen Vorgabewert für die Zieltemperatur beziehungsweise den Zieldruck hinaus erhöht oder im Sinne einer Nachjustage abweichend eingestellt werden. In analoger Weise kann vorgesehen sein, dass ein im laufenden Fertigungsverfahrensschritt abzufahrendes Temperatur-Zeit-Profil und/oder ein Druck-Zeit-Profil abhängig von den Messwerten und/oder den daraus gewonnenen Daten angepasst beziehungsweise geändert wird.

Aus den weiteren Unteransprüchen und der nachfolgenden Beschreibung sind weitere Vorteile, Merkmale und Einzelheiten der Erfindung zu entnehmen.

Die Zeichnungen dienen lediglich beispielhaft der Klarstellung der Erfindung und haben keinen einschränkenden Charakter auf die durch die Ansprüche definierte Erfindung.

Es zeigen:

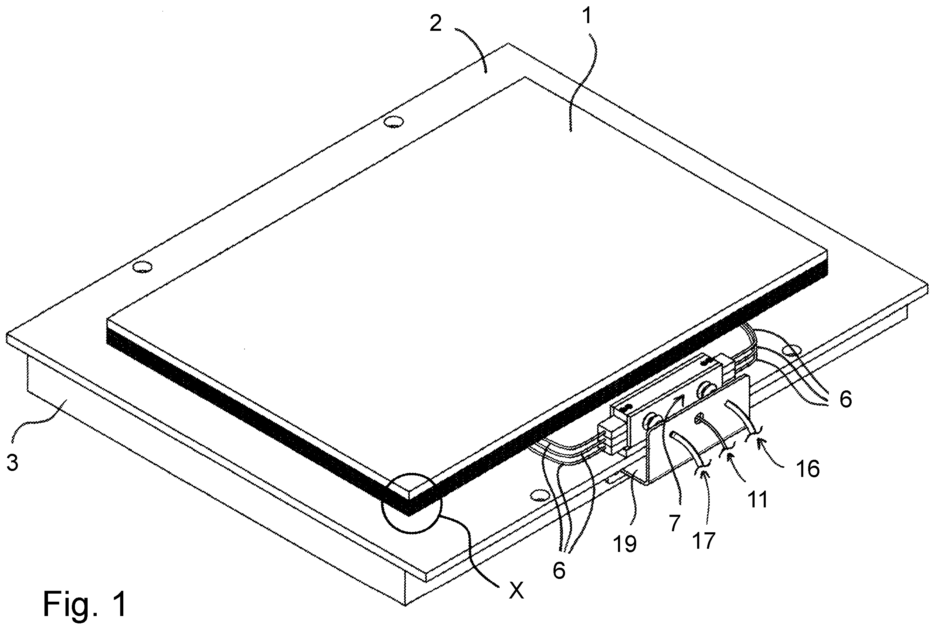

- Fig. 1: eine perspektivische Teilansicht einer erfindungsgemäßen Vorrichtung zur Herstellung von mehrschichtigen Leiterplatten mit einem bestückten mehrteiligen Werkzeug, einem Werkzeuglogikmodul und einem Messwertübertragungsmodul, wobei ein Werkzeugunterteil des Werkzeugs an eine Heizplatte angelegt ist und eine Empfangseinheit des Messwertübertragungsmodul an der Heizplatte gehalten wird,

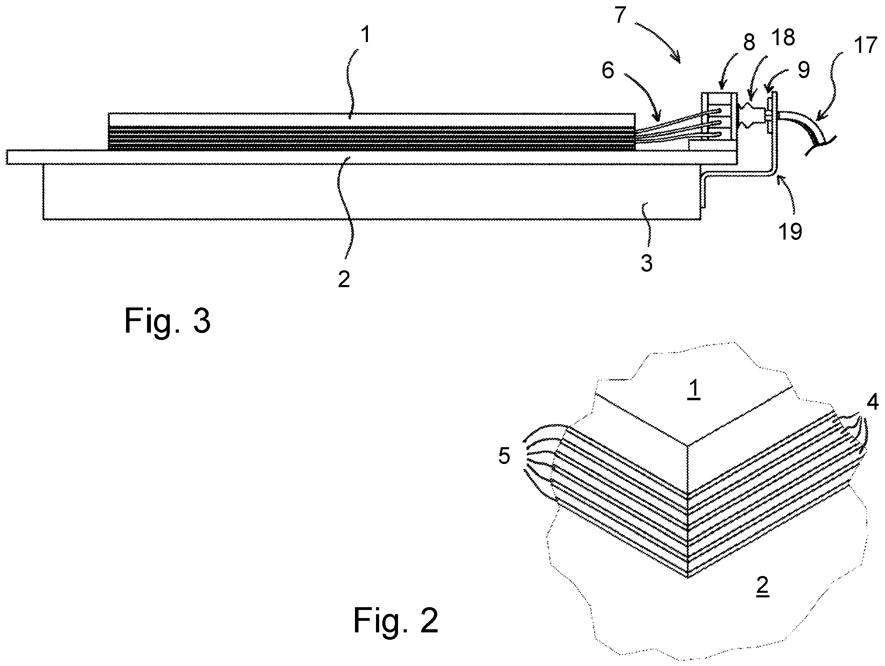

- Fig. 2: eine vergrößerte Darstellung eines Details X der Anordnung nach Fig. 1,
- Fig. 3: eine Seitenansicht der Anordnung nach Fig. 1,

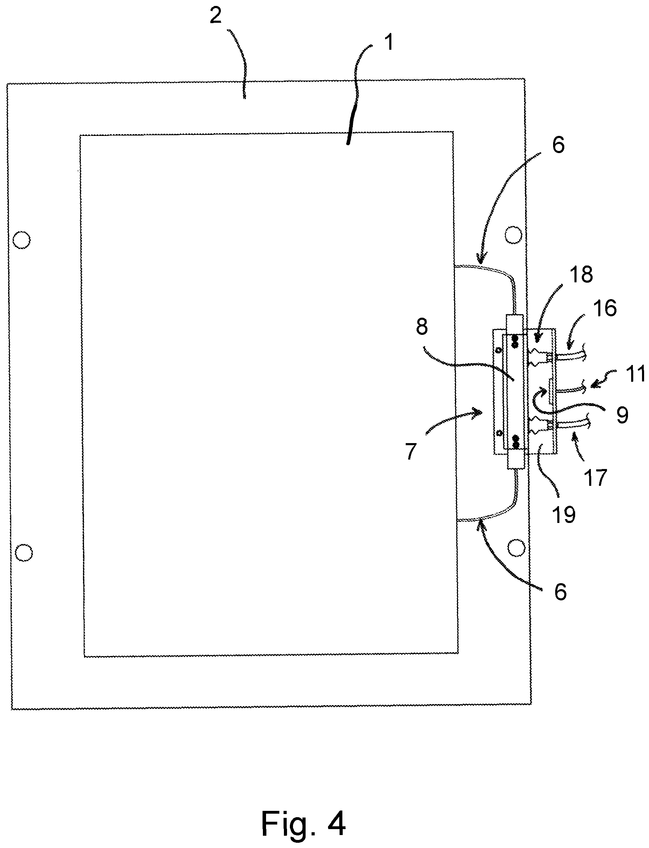

- Fig. 4: eine Aufsicht auf die Anordnung nach Fig. 1,

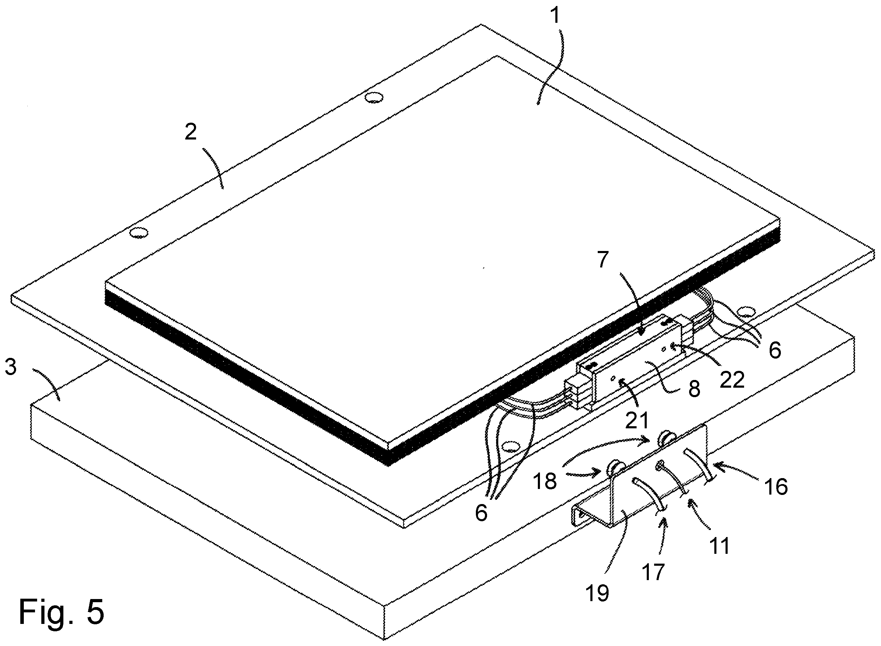

- Fig. 5: eine Explosionsdarstellung der Anordnung nach Fig. 1, wobei das bestückte mehrteilige Werkzeug mit dem daran montierten Werkzeuglogikmodul beabstandet von der Heizplatte angeordnet ist, und

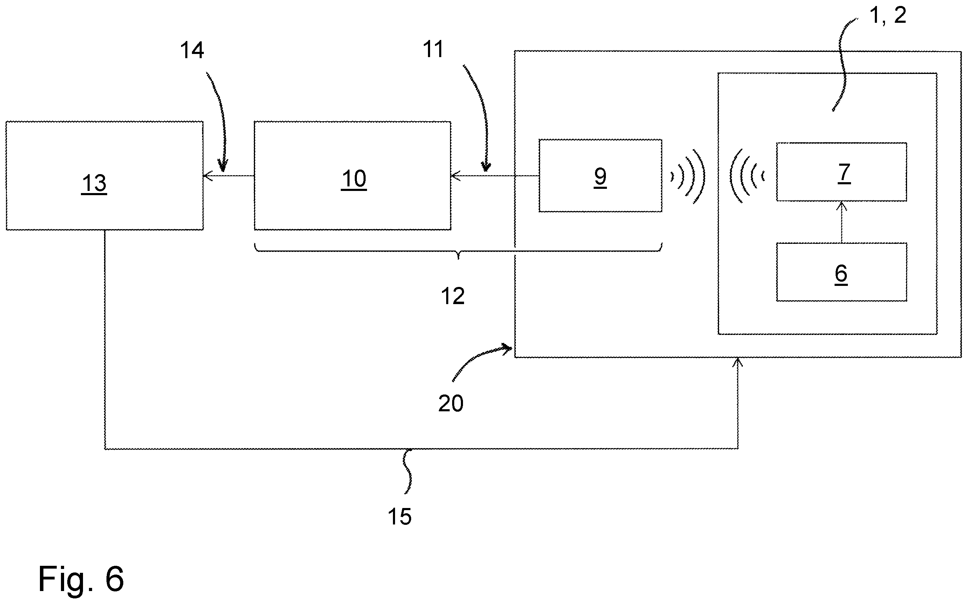

- Fig. 6: eine Prinzipdarstellung der erfindungsgemäßen Vorrichtung als Teil einer Etagen-Heizpresse mit einer Fertigungssteuereinrichtung.

Eine erfindungsgemäße Vorrichtung zur Herstellung von mehrschichtigen Leiterplatten umfasst ein mehrteiliges Werkzeug mit einem Werkzeugunterteil 2 und einem Werkzeugoberteil 1, einen Messwertgeber und ein Werkzeuglogikmodul 7, dem vom Messwertgeber erfasste Messwerte über eine Signalleitung zugeführt werden. Weiter umfasst die Vorrichtung ein Messwertübertragungsmodul 12 mit einer Empfangseinheit 9 und einer Übertragungseinheit 10 sowie eine der Weiterübertragung der Messwerte beziehungsweise daraus gewonnener Daten dienenden Datenleitung 14. Die Empfangseinheit 9 und die Übertragungseinheit 10 des Messwertübertragungsmoduls 12 sind räumlich getrennt voneinander angeordnet und vorliegend über eine Leitung 11 datentechnisch miteinander verbunden.

Das Werkzeug mit dem Werkzeugoberteil 1 und dem Werkzeugunterteil 2, das Werkzeuglogikmodul 7, der Messwertgeber und die Empfangseinheit 9 des Messwertübertragungsmoduls 12 sind bei der bestimmungsgemäßen Verwendung der erfindungsgemäßen Vorrichtung zusammen mit einer Mehrzahl von Heizplatten 3 in einer Thermokompressionskammer 20 einer Etagen-Heizpresse angeordnet. Die Übertragungseinheit 10 des Messwertübertragungsmoduls 12 sowie eine über die Datenleitung 14 mit der Übertragungseinheit 10 verbundene Fertigungssteuereinrichtung 13 der Etagen-Heizpresse sind außerhalb der Thermokompressionskammer 20 vorgesehen. Die Fertigungssteuereinrichtung 13, die Thermokompressionskammer 20 sowie die Heizplatten 3 sind nicht Teil der erfindungsgemäßen Vorrichtung. Sie gehören jedoch zusammen mit der erfindungsgemäßen Vorrichtung zur Etagen-Heizpresse.

Bei der Herstellung mehrschichtiger Leiterplatten werden zunächst in einem vorbereitenden Konfektionsverfahrensschritt außerhalb der Thermokompressionskammer 20 der Etagen-Heizpresse Funktionsschichten 5 und Isolationsschichten 4 der herzustellenden Leiterplatte abwechselnd in dem Werkzeug angeordnet und zwischen dem Werkzeugoberteil 1 und dem Werkzeugunterteil 2 geschichtet. Während des Schichtens werden im vorliegenden Ausführungsbeispiel der Erfindung insgesamt sechs Thermodrähte 6, die zugleich den Messwertgeber und die Signalleitung der erfindungsgemäßen Vorrichtung bilden, zwischen den Schichten 4, 5 angeordnet. Die Anordnung der Thermodrähte 6 erfolgt dabei vorzugsweise zwischen unterschiedlichen Schichten 4, 5 so, dass die Thermodrähte 6 außerhalb der später durch Zuschnitt herzustellenden Leiterplatte des Schichtaufbaus liegen.

Die Thermodrähte 6 werden aus dem Schichtaufbau hinaus zum Werkzeuglogikmodul 7 geführt und dort kontaktiert. Das Werkzeuglogikmodul 7, welches ein Gehäuse 8, einen Sender sowie weitere Funktionskomponenten zur Entgegennahme und/oder Speicherung und/oder Nachbearbeitung der Messwerte vorsieht, ist an dem Werkzeugunterteil 2 des Werkzeugs festgelegt. Der interne Aufbau des Werkzeuglogikmoduls 7 ist so realisiert, dass die über die Signalleitung zugeführte Messwerte zu dem Sender gelangen.

In Vorbereitung der Herstellung der mehrschichtigen Leiterplatten wird in der vorbeschriebenen Weise eine Mehrzahl von Werkzeugen vorkonfiguriert beziehungsweise vorkonfektioniert und in einem Bestückungsverfahrensschritt über geeignete Handhabungsmittel bevorzugt automatisiert zur Etagen-Heizpresse transportiert. Die Mehrzahl der Werkzeuge werden dann in die Thermokompressionskammer 20 der Etagen-Heizpresse so eingesetzt, dass jedes Werkzeug mit einer Unterseite seines Werkzeugunterteils 2 von oben auf eine Heizplatte 3 gelegt und relativ zu derselben positioniert wird. Die Anzahl der Heizplatten 3 in der Thermokompressionskammer 20 ist dabei bevorzugt so gewählt, dass unter jedem Werkzeugunterteil 2 eine Heizplatte 3 vorgesehen ist und dass zusätzlich eine weitere Heizplatte 3 oberhalb des Werkzeugoberteils 1 eines obersten Werkzeugs in der Thermokompressionskammer 20 vorgesehen wird.

Beim Einsetzen der Werkzeuge in die Thermokompressionskammer 20 der Etagen-Heizpresse wird das Werkzeuglogikmodul 7 mit dem Sender benachbart zu der ebenfalls in der Thermokompressionskammer 20 installierten Empfangseinheit 9 des Messwertübertragungsmoduls 12 positioniert. Zwischen dem Sender des Werkzeuglogikmoduls 7 und der Empfangseinheit 9 des Messwertübertragungsmoduls 12 ist ein Abstand dabei so gewählt, dass eine drahtlose Übertragung der Messwerte oder der daraus gewonnenen Daten von dem Sender des Werkzeuglogikmoduls 7 zu der Empfangseinheit 9 möglich ist.

Die drahtlose Übertragung erfolgt vorliegend exemplarisch unter Verwendung einer Nahfeldkommunikationsroutine. Der Sender des Werkzeuglogikmoduls 7 umfasst dann beispielsweise eine NFC-Spule (NFC: Near Field Communication) und die Empfangseinheit 9 des Messwertübertragungsmoduls 12 ist als ein NFC-Reader ausgebildet beziehungsweise sieht einen solchen vor. Die NFC-Spule und der NFC-Reader wirken dabei so zusammen, dass die Messwerte beziehungsweise die daraus gewonnenen Daten kabellos übertragen beziehungsweise weitergegeben werden.

Beispielsweise ist eine Energieversorgung für das Werkzeuglogikmoduls (7) im Rahmen der NFC-Kommunikation über das Messwertübertragungsmodul (12) realisiert.

Um im Zuge der Positionierung der Werkzeuge an den Heizplatten 3 zugleich den Sender eines jeden Werkzeugs relativ zu der Empfangseinheit 9 des dem jeweiligen Werkzeug zugeordneten Messwertübertragungsmoduls 12 zu gewährleisten, ist an jeder Heizplatte 3 ein Trägerkörper 19 vorgesehen, an dem die Empfangseinheit 9 festgelegt ist. Im vorliegenden Ausführungsbeispiel der Erfindung ist der Trägerkörper 19 exemplarisch durch einen Doppel-L- beziehungsweise Z-förmigen Profilkörper gebildet.

Um nun die in dem Werkzeug angeordneten Funktions- und Isolationsschichten 4, 5 miteinander zu verbinden, wird die Thermokompressionskammer 20 auf zirka 180 °C aufgeheizt. Zugleich werden die Heizplatten 3 zusammengefahren und auf diese Weise die Schichten 4, 5 in den Werkzeugen gegeneinander angedrückt. Nach einer gewissen Haltezeit, die insbesondere abhängig von der Temperatur, dem Druck und dem Material der verwendeten Funktions- und Isolationsschichten 4, 5 variiert, sind die Schichten 4, 5 dann stoffschlüssig miteinander verbunden, wobei benachbarte Funktionsschichten 5 jeweils durch eine Isolationsschicht 4 voneinander getrennt und gegeneinander isoliert sind. Die Thermodrähte 6 sind fest mit dem Schichtaufbau verbunden. Sie können als verlorene Sensoren nicht wiederverwendet werden.

Um die Funktionskomponenten des Werkzeuglogikmoduls 7 und insbesondere den Sender gegen eine zu hohe Temperatur zu schützen, ist im vorliegenden Ausführungsbeispiel der Erfindung eine fluidische Kühlung für das Werkzeuglogikmodul 7 realisiert. Die fluidische Kühlung sieht zwei Fluidleitungen 16, 17 vor, über die ein Kühlfluid zu- und abgeführt wird. Darüber hinaus sind an dem Gehäuse 8 des Werkzeuglogikmoduls 7 eine Einlassöffnung 21 und eine Auslassöffnung 22 für das Kühlfluid vorgesehen.

Zum Verbinden der Einlass- und Auslassöffnung 21, 22 einerseits mit den Fluidleitungen 16, 17 andererseits dienen elastische Anschlusshülsen 18, welche an den Trägerkörper 19 auf einer dem Werkzeuglogikmoduls zugewandten Seite festgelegt sind. Die Anschlusshülsen 18 sind mit den Fluidleitungen 16, 17 verbunden.

Darüber hinaus sind die Anschlusshülsen 18 an den Trägerkörper 19 so positioniert, dass sie beim Einsetzen des Werkzeugs in die Thermokompressionskammer 20 an die Einlass- und Auslassöffnung 21, 22 angesetzt werden. Die Anschlusshülsen 18 können sich dabei elastisch verformen. Infolge der Verformung wird eine Anpresskraft bereitgestellt, die zu einer hinreichend dichten Verbindung und einer nur geringen Leckage führt.

Das Kühlfluid gelangt über eine erste Fluidleitung 16 und eine erste Anschlusshülse 18 zu der Einlassöffnung 21 des Gehäuses 8 und fließt über die Auslassöffnung 22, eine zweite Anschlusshülse 18 sowie eine zweite Fluidleitung 17 ab. Das Gehäuse 8 selbst dient vorliegend als Fluidkanal und verbindet die Einlass- und Auslassöffnung 21, 22.

Auf diese Weise ist eine Kühlung der in den Gehäuse 8 installierten Funktionskomponenten des Werkzeuglogikmoduls 7 realisiert.

Als Kühlfluid kann beispielsweise Umgebungsluft verwendet werden, die von außerhalb der Thermokompressionskammer zuführt wird.

Durch die Verwendung der erfindungsgemäßen Vorrichtung als Teil einer Etagen-Heizpresse kann die Herstellung mehrschichtiger Leiterplatten verbessert werden. Die mit Hilfe des Thermodrahts bestimmten Messwerte und/oder die daraus gewonnenen Daten können der Fertigungssteuereinrichtung (13) der Etagen-Heizpresse online, das heißt unmittelbar im laufenden Fertigungsverfahrensschritt zugeführt werden. Die Fertigungssteuereinrichtung (13) kann anhand der Messwerte und/oder der daraus gewonnenen Daten entscheiden, ob ein Eingriff in den laufenden Fertigungsverfahrensschritt notwendig ist, und beispielsweise die Haltezeit verlängern oder verkürzen oder die Temperatur beziehungsweise den Druck nachregeln. Die Fertigungssteuereinrichtung kann insofern insbesondere dazu ausgebildet sein, die Messwerte und/oder die daraus gewonnenen Daten mit gespeicherten und/oder berechneten Vorgabewerten, insbesondere mit Vorgabewerten für die Dauer des laufenden Fertigungsverfahrensschritts, für eine Zieltemperatur, auf die die Thermokompressionskammer (20) aufgeheizt wird, oder für einen Zieldruck, mit dem das Werkzeug in der Thermokompressionskammer (20) beaufschlagt wird, zu vergleichen. Auf diese Weise können Abweichungen von Soll- und Istverlauf frühzeitig erkannt und Maßnahmen zur Fehlervermeidung beziehungsweise Fehlerbehebung rechtzeitig eingeleitet werden. Zudem können die Messwerte und/oder die daraus gewonnenen Daten zu Dokumentationszwecken gespeichert werden.

Gleiche Bauteile und Bauteilfunktionen sind durch gleiche Bezugszeichen gekennzeichnet.

## Patentansprüche

1. Verfahren zur Herstellung von mehrschichtigen Leiterplatten,
- wobei im Rahmen eines Fertigungsverfahrensschritts ein Werkzeugoberteil (1) und ein Werkzeugunterteil (2) eines mehrteiligen Werkzeugs mit dazwischen vorgesehenen mehreren Funktionsschichten (5) und wenigstens einer Isolationsschicht (4) einer herzustellenden Leiterplatte und mindestens einem Messwertgeber in einer Thermokompressionskammer (20) gegeneinander angedrückt und erwärmt werden und dabei Messwerte mit dem Messwertgeber erfasst werden,
- wobei die Messwerte und/oder daraus gewonnene Daten während des laufenden Fertigungsverfahrensschritts an eine Fertigungssteuereinrichtung (13) übertragen werden und dass die Messwerte und/oder die daraus gewonnenen Daten von der Fertigungssteuereinrichtung (13) für die Überwachung des laufenden Fertigungsverfahrensschritts und/oder zur Steuerung des laufenden Fertigungsverfahrensschritts in Bezug auf einen Vorgabewert für eine Messgröße des Messwertgebers verarbeitet werden,
**dadurch gekennzeichnet, dass**
- vor dem Fertigungsverfahrensschritt zunächst im Rahmen eines Konfektionsverfahrensschritts die mehreren Funktionsschichten (5) und die wenigstens eine Isolationsschicht (4) zwischen dem Werkzeugunterteil (2) und dem Werkzeugoberteil (1) geschichtet angeordnet werden und der wenigstens eine Messwertgeber zwischen dem Werkzeugoberteil (1) und dem Werkzeugunterteil (2) so positioniert wird, dass der Messwertgeber an wenigstens einer Funktionsschicht (5) und/oder Isolationsschicht (4) anliegt, und
- dass vor dem Fertigungsverfahrensschritt dann im Rahmen eines Bestückungsverfahrensschritts eine Mehrzahl von vorkonfektionierten Werkzeugen mit den mehreren Funktionsschichten (5) und der wenigstens einen Isolationsschicht (4) und dem Messwertgeber über geeignete Handhabungsmittel zu einer Etagen-Heizpresse transportiert und in die Thermokompressionskammer (20) der Etagen-Heizpresse so eingesetzt wird, dass jedes Werkzeug mit einer Unterseite seines Werkzeugunterteils (2) von oben auf eine Heizplatte (3) gelegt und relativ zu derselben positioniert wird.

2. Verfahren nach Anspruch 1, **dadurch gekennzeichnet, dass** die Messwerte jedenfalls abschnittsweise kabellos an die Fertigungssteuereinrichtung (13) übertragen werden.

3. Verfahren nach Anspruch 2, **dadurch gekennzeichnet, dass** die Messwerte hybrid, das heißt jedenfalls abschnittsweise kabellos und abschnittsweise kabelbeziehungsweise leitungsgebunden übertragen werden.

4. Verfahren nach einem der Ansprüche 1 bis 3, **dadurch gekennzeichnet, dass** die Messwerte kabel- beziehungsweise leitungsgebunden aus dem Werkzeug hinausgeführt werden.

5. Verfahren nach einem der Ansprüche 1 bis 4, **dadurch gekennzeichnet, dass** die Messwerte kabel- beziehungsweise leitungsgebunden aus der Thermokompressionskammer (20) hinaus zu der außerhalb der Thermokompressionskammer (20) vorgesehenen Fertigungssteuereinrichtung (13) geführt werden.

6. Verfahren nach einem der Ansprüche 2 bis 5, **dadurch gekennzeichnet, dass** die Messwerte kabellos von einem in der Thermokompressionskammer (20) angeordneten Sender zu einer mit dem Sender zusammenwirkenden Empfangseinheit (9) übertragen werden.

7. Verfahren nach Anspruch 6, **dadurch gekennzeichnet, dass** der Sender in der Thermokompressionskammer (20) fluidisch gekühlt wird, wobei ein Kühlfluid über wenigstens eine Fluidleitung (16, 17) zu- und/oder abgeführt wird.

8. Verfahren nach einem der Ansprüche 1 bis 7, **dadurch gekennzeichnet, dass** der Sender zusammen mit dem Werkzeug oder als Teil desselben beim Einsetzen des Werkzeugs in die Thermokompressionskammer (20) relativ zu der Empfangseinheit (9) positioniert und/oder ausgerichtet wird.

9. Verfahren nach einem der Ansprüche 1 bis 8, **dadurch gekennzeichnet, dass** als Messwert eine Temperatur und/oder ein Druck und/oder ein Feuchtewert bestimmt werden.

10. Verfahren nach einem der Ansprüche 1 bis 9, **dadurch gekennzeichnet, dass** bei der Verarbeitung der Messwerte und/oder der daraus gewonnenen Daten durch die Fertigungssteuereinrichtung (13) die Messwerte und/oder die daraus gewonnenen Daten mit gespeicherten Referenzwerten verglichen werden, wobei bevorzugt die Vorgabewerte als Referenzwerte für die Messgröße des Messwertgebers dem Vergleich zugrunde gelegt werden.

11. Verfahren nach einem der Ansprüche 1 bis 10, **dadurch gekennzeichnet, dass** eine Dauer des laufenden Fertigungsverfahrensschritts abhängig von den Messwerten und/oder den daraus gewonnenen Daten bestimmt wird und/oder dass der laufenden Fertigungsverfahrensschritts über einen Vorgabewert für die Dauer des laufenden Fertigungsverfahrensschritt hinaus fortgeführt oder vor dem Erreichen des Vorgabewerts für die Dauer des laufenden Fertigungsverfahrensschritt beendet wird.

12. Verfahren nach einem der Ansprüche 1 bis 11, **dadurch gekennzeichnet, dass** eine Zieltemperatur, auf die die Thermokompressionskammer (20) aufgeheizt wird, im laufenden Fertigungsverfahrensschritts abhängig von den Messwerten und/oder den daraus gewonnenen Daten über einen Vorgabewert für die Zieltemperatur hinaus erhöht wird und/oder abweichend von dem Vorgabewert für die Zieltemperatur eingestellt wird.

13. Verfahren nach einem der Ansprüche 1 bis 12, **dadurch gekennzeichnet, dass** ein Zieldruck, mit dem das Werkzeug in der Thermokompressionskammer (20) beaufschlagt wird, im laufenden Fertigungsverfahrensschritts abhängig von den Messwerten und/oder den daraus gewonnenen Daten über einen Vorgabewert für den Zieldruck hinaus erhöht wird und/oder abweichend von dem Vorgabewert für den Zieldruck eingestellt wird.

## Claims

1. A method for manufacturing multi-layer circuit boards,
- wherein, within the scope of a production method step, a tool upper part (1) and a tool lower part (2) of a multi-part tool with multiple functional layers (5) and at least one insulation layer (4) of a circuit board to be produced and at least one measurement value sensor provided therebetween are pressed against one another and heated in a thermo-compression chamber (20) and in doing so measured values are captured with the measurement value sensor,
- wherein the measured values and/or data obtained therefrom are transmitted to a production control device (13) during the ongoing production method step and that the measured values and/or the data obtained therefrom are processed by the production control device (13) for monitoring the ongoing production method step and/or for controlling the ongoing production method step with respect to a default value for a measurand of the measurement value sensor,
**characterized in that**
- before the production method step, first, within the scope of an assembling method step, the multiple functional layers (5) and the at least one insulation layer (4) are arranged in a layered manner between the tool lower part (2) and the tool upper part (1), and the at least one measurement value sensor is positioned between the tool upper part (1) and the tool lower part (2) such that the measurement value sensor rests against at least one functional layer (5) and/or insulation layer (4), and
- that before the production method step, then, within the scope of an equipping method step, a plurality of preassembled tools with the multiple functional layers (5) and the at least one insulation layer (4) and the measurement value sensor are transported via suitable handling means to a multi-platen heat press and inserted into the thermo-compression chamber (20) of the multi-platen heat press such that each tool is placed with an underside of its tool lower part (2) from above onto a heating plate (3) and positioned relative thereto.

2. The method according to claim 1, **characterized in that** the measured values are transmitted in any case partially wirelessly to the production control device (13).

3. The method according to claim 2, **characterized in that** the measured values are transmitted in a hybrid manner, i.e. in any case partially wirelessly and partially in a wire-bound or line-bound manner.

4. The method according to any of claims 1 to 3, **characterized in, that** the measured values are guided out of the tool in a wire-bound or line-bound manner.

5. The method according to any of claims 1 to 4, **characterized in that** the measured values are guided out of the thermo-compression chamber (20) in a wire-bound or line-bound manner to the production control device (13) provided outside the thermo-compression chamber (20).

6. The method according to any of claims 2 to 5, **characterized in that** the measured values are transmitted wirelessly from a transmitter arranged in the thermo-compression chamber (20) to a receiving unit (9) cooperating with the transmitter.

7. The method according to claim 6, **characterized in that** the transmitter is fluidically cooled in the thermo-compression chamber (20), wherein a cooling fluid is supplied and/or discharged via at least one fluid line (16, 17).

8. The method according to any of claims 1 to 7, **characterized in that** when inserting the tool into the thermo-compression chamber (20) the transmitter together with the tool or as part thereof is positioned and/or aligned relative to the receiving unit (9).

9. The method according to any of claims 1 to 8, **characterized in that** a temperature and/or a pressure and/or a humidity value are determined as a measured value.

10. The method according to any of claims 1 to 9, **characterized in that** when processing the measured values and/or the data obtained therefrom by the production control device (13) the measured values and/or the data obtained therefrom are compared with stored reference values, wherein preferably the default values as reference values for the measurand of the measurement value sensor are used as a basis for the comparison.

11. The method according to any of claims 1 to 10, **characterized in that** a duration of the ongoing production method step is determined depending on the measured values and/or the data obtained therefrom, and/or that the ongoing production method step is continued beyond a default value for the duration of the ongoing production method step or is terminated before reaching the default value for the duration of the ongoing production method step.

12. The method according to any of claims 1 to 11, **characterized in that** a target temperature to which the thermo-compression chamber (20) is heated is increased in the ongoing production method step, depending on the measured values and/or the data obtained therefrom, beyond a default value for the target temperature and/or is set deviating from the default value for the target temperature.

13. The method according to any of claims 1 to 12, **characterized in that** a target pressure the tool in the thermo-compression chamber (20) is subjected to is increased in the ongoing production method step, depending on the measured values and/or the data obtained therefrom, beyond a default value for the target pressure and/or is set deviating from the default value for the target pressure.

## Revendications

1. Procédé de fabrication de cartes de circuits imprimés multicouches
- dans le cadre duquel, lors d'une étape de production, une partie supérieure (1) et une partie inférieure (2) d'un outil en plusieurs parties entre lesquelles sont prévues plusieurs couches fonctionnelles (5) et au moins une couche d'isolation (4) d'une carte de circuit imprimé à fabriquer et au moins un capteur de mesure sont chauffées et pressées les unes contre les autres dans une chambre de thermocompression (20), des valeurs à mesurer étant alors saisies avec le capteur de mesure,
- et dans le cadre duquel les valeurs mesurées et/ou les données obtenues à partir de celles-ci pendant l'étape de production en cours sont transmises à un dispositif de commande de production (13), les valeurs mesurées et/ou les données obtenues à partir de celles-ci étant traitées par le dispositif de commande de production (13) pour le contrôle de l'étape de production en cours et/ou pour la commande de l'étape de production en cours en fonction d'une valeur de consigne prédéfinie pour une valeur mesurée par le capteur de mesure,
**caractérisé en ce que**
- avant l'étape de production, la pluralité de couches fonctionnelles (5) et la (les) couche(s) d'isolation (4) sont tout d'abord, dans le cadre d'une étape de confection, empilées et agencées entre la partie inférieure (2) et la partie supérieure (1) de l'outil, et **en ce que** le (les) capteur(s) de mesure est (sont) positionné(s) entre la partie inférieure (2) et la partie supérieure (1) de l'outil de façon à ce que le capteur de mesure soit en contact avec au moins une couche fonctionnelle (5) et/ou une couche d'isolation (4), et
- avant l'étape de production, une pluralité d'outils préconfectionnés avec la pluralité de couches fonctionnelles (5) et la (les) couche(s) d'isolation (4) et le capteur de mesure sont, dans le cadre d'une étape d'équipement, transportés à l'aide de moyens de manipulation appropriés vers une presse chauffante à étages et disposés dans la chambre de thermocompression (20) de la presse chauffante à étages de façon à ce que chaque outil soit posé d'en haut avec une face inférieure de sa partie inférieure (2) sur une plaque chauffante (3) et positionné sur celle-ci.

2. Procédé selon la revendication 1, **caractérisé en ce que** les valeurs mesurées sont, en tout cas partiellement, transmises sans fil au dispositif de commande de production (13).

3. Procédé selon la revendication 2, **caractérisé en ce que** les valeurs mesurées sont transmises de façon hybride, c'est-à-dire en tout cas partiellement sans fil et partiellement par fil ou conducteur.

4. Procédé selon l'une des revendications 1 à 3, **caractérisé en ce que** les valeurs mesurées sont conduites hors de l'outil par fil ou conducteur.

5. Procédé selon l'une des revendications 1 à 4, **caractérisé en ce que** les valeurs mesurées sont conduites hors de la chambre de thermocompression (20) par fil ou conducteur vers le dispositif de commande de production (13) prévu à l'extérieur de la chambre de thermocompression (20).

6. Procédé selon l'une des revendications 2 à 5, **caractérisé en ce que** les valeurs mesurées sont transmises sans fil par un émetteur agencé dans la chambre de thermocompression (20) à une unité de réception (9) agissant en association avec l'émetteur.

7. Procédé selon la revendication 6, **caractérisé en ce que** l'émetteur dans la chambre de thermocompression (20) est refroidi par un fluide, un fluide de refroidissement étant amené et/ou évacué par au moins une conduite de fluide (16, 17).

8. Procédé selon l'une des revendications 1 à 7, **caractérisé en ce que**, lors de l'introduction de l'outil dans la chambre de thermocompression (20), l'émetteur avec l'outil ou comme partie de celui-ci est positionné et/ou orienté par rapport à l'unité de réception (9).

9. Procédé selon l'une des revendications 1 à 8, **caractérisé en ce que** la valeur spécifiée comme valeur à mesurer est une température et/ou une pression et/ou un taux d'humidité.

10. Procédé selon l'une des revendications 1 à 9, **caractérisé en ce que**, lors du traitement par le dispositif de commande de production (13) des valeurs mesurées et/ou des données obtenues à partir de celles-ci, ces valeurs ou données sont comparées à des valeurs de référence enregistrées, les valeurs prises comme valeurs de référence pour la comparaison avec la valeur mesurée par le capteur de mesure étant de préférence les valeurs de consigne.

11. Procédé selon l'une des revendications 1 à 10, **caractérisé en ce qu'**une durée de l'étape de production en cours est déterminée en fonction des valeurs mesurées et/ou des données obtenues à partir de celles-ci, et/ou **en ce que** l'étape de production en cours est poursuivie au-delà d'une valeur de consigne de la durée de l'étape de production en cours ou cesse avant la fin de la durée de consigne de cette étape.

12. Procédé selon l'une des revendications 1 à 11, **caractérisé en ce qu'**une température cible pour le chauffage de la chambre de thermocompression (20) est, en fonction des valeurs mesurées et/ou des données obtenues à partir de celles-ci, augmentée au-delà d'une température cible de consigne pendant l'étape de production en cours et/ou réglée sur une valeur cible différente de la température cible de consigne.

13. Procédé selon l'une des revendications 1 à 12, **caractérisé en ce qu'**une pression cible agissant sur l'outil dans la chambre de thermocompression (20) est, en fonction des valeurs mesurées et/ou des données obtenues à partir de celles-ci, augmentée au-delà d'une pression cible de consigne pendant l'étape de production en cours et/ou réglée sur une valeur cible différente de la pression cible de consigne.
